# EUROPEAN PATENT APPLICATION

(11) **EP 4 651 203 A1**
(43) Date of publication of application: **19.11.2025**
(21) Application number: 25175567.4
(22) Date of filing: 10.05.2025
(51) Int. Cl.: H01L 23/473, H01L 25/07

(54) **DIRECT LIQUID COOLING OF SEMICONDUCTOR DEVICES**

(30) Priority: 15.05.2024 US 202418664744; 28.04.2025 US 202519191530
(71) Applicant: Littelfuse, Inc., Rosemont, Illinois 60018 (US)
(72) Inventor: Schulz, Martin, Rosemont, 60018 (US)
(74) Representative: Arnold & Siedsma

(57) **Abstract**

A system and associated method for direct liquid cooling of semiconductor devices. The system includes at least one semiconductor device is positioned on a die substrate and at least one cold plate disposed within the die substrate and containing a cooling liquid. The cold plate is positioned proximate to the semiconductor device and configured to at least partially dissipate heat using the cooling liquid from the semiconductor device during operation of the semiconductor device.

## Description

### TECHNICAL FIELD

This disclosure relates generally to the field of semiconductor devices, and in particular, to direct liquid cooling of semiconductor devices.

### BACKGROUND

The cooling of power semiconductors is a critical aspect of electronic device management, especially as the power density and heat generation within these devices increase. Effective cooling systems are essential to maintain the reliability and performance of power semiconductor devices, such as MOSFETs and IGBTs, which are integral to a wide range of applications from consumer electronics to electric vehicles. Traditional cooling methods, such as metal heat sinks, are often insufficient for high heat flux scenarios, prompting the development of advanced cooling techniques. These include passive and active cooling systems, the use of thermoelectric modules, and immersion in dielectric fluids. Developments in cooling technology seek to enhance heat dissipation and reduce thermal resistance, thereby enabling power semiconductors to operate efficiently within safe temperature ranges and extending their operational lifespan. However, existing technologies typically require various isolation components to separate power semiconductor devices and cooling components, thereby reducing their effectiveness and efficiency.

### BRIEF SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The current subject matter relates to a system that may include at least one semiconductor device positioned on a die substrate, and at least one cold plate disposed within the die substrate and containing a cooling liquid. The cold plate may be positioned proximate to the semiconductor device and may be configured to at least partially dissipate heat using the cooling liquid from the semiconductor device during operation of the semiconductor device.

The cold plate may include an enclosed channel containing the cooling liquid.

The enclosed channel may include an inlet and an outlet. The inlet may be configured to allow inflow of the cooling liquid into the enclosed channel and the outlet may be configured to allow outflow of the cooling liquid from the enclosed channel. The cooling liquid may be configured to circulate within the enclosed channel.

The system may also include at least another semiconductor device positioned on the die substrate. The other semiconductor device may be coupled to the semiconductor device. The semiconductor device and the other semiconductor device may be coupled using at least one of the following: a bond wire, a clip, and any combination thereof.

The cold plate may be positioned proximate to the other semiconductor device and configured to at least partially dissipate heat from at least one of: the semiconductor device and the other semiconductor device during operation of at least one of: the semiconductor device and the other semiconductor device.

The system may include at least another cold plate disposed within the die substrate. The other cold plate may include another enclosed channel containing the cooling liquid. The other cold plate may be positioned proximate to the other semiconductor device and may be configured to at least partially dissipate heat using the cooling liquid from the other semiconductor device during operation of the other semiconductor device. The other enclosed channel is not connected to the enclosed channel. Alternatively, or in addition, the other enclosed channel may be connected to the enclosed channel. The cooling liquid may be configured to circulate between the enclosed channel and the other enclosed channel.

The one cold plate may be positioned below at least one of: the semiconductor device and the other semiconductor device.

The semiconductor device may include a semiconductor switching device. The semiconductor switching device may include an insulated-gate bipolar transistor. The other semiconductor device may be a diode.

The cold plate may be an electrically conductive cold plate.

The current subject matter includes a system. The system may include a first semiconductor device positioned on a die substrate, and a first cold plate disposed within the die substrate and containing a first cooling liquid, where the first cold plate may be positioned proximate to the first semiconductor device and configured to at least partially dissipate heat using the first cooling liquid from the first semiconductor device during operation of the first semiconductor device. The system may also include a second semiconductor device positioned on the die substrate, and a second cold plate disposed within the die substrate and containing a second cooling liquid, where the second cold plate may be positioned proximate to the second semiconductor device and configured to at least partially dissipate heat using the second cooling liquid from the second semiconductor device during operation of the second semiconductor device. The first cold plate may be galvanically isolated from the second cold plate using an isolating mechanism.

The current subject matter may include one or more of the following optional features. The first cold plate may include a first enclosed channel containing the cooling liquid. The second cold plate may include a second enclosed channel containing the cooling liquid. At least one of the first and second enclosed channels may include an inlet and an outlet. The inlet may be configured to allow inflow of the cooling liquid into at least one of the first and second enclosed channels and the outlet may be configured to allow outflow of the cooling liquid from at least one of the first and second enclosed channels. The cooling liquid may be configured to circulate within the first and second enclosed channels.

The first semiconductor device may include an insulated-gate bipolar transistor and the second semiconductor device may be a diode.

The cooling liquid may be an electrically conductive cooling liquid.

The current subject matter relates to a system that may include a first cold plate containing a first cooling liquid. The first cold plate may be positioned proximate to a first semiconductor device and configured to at least partially dissipate heat using the first cooling liquid from the first semiconductor device during operation of the first semiconductor device. The system may also include a second cold plate containing a second cooling liquid. The second cold plate may be positioned proximate to a second semiconductor device and configured to at least partially dissipate heat using the second cooling liquid from the second semiconductor device during operation of the second semiconductor device. The second cold plate may be separate from the first cold plate.

The details of one or more variations of the subject matter described herein are set forth in the accompanying drawings and the description below. Other features and advantages of the subject matter described herein will be apparent from the description and drawings, and from the claims.

The disclosure also includes the use of the system in cooling a semiconductor device; a system, comprising a die substrate for positioning a semiconductor device; and a cold plate disposed within the die substrate and containing a cooling liquid; the cold plate positionable proximate to the semiconductor device, the cold plate configured to at least partially dissipate heat, using the cooling liquid, from the semiconductor device during operation of the semiconductor device; and the use of this for cooling a semiconductor device.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosure. In the drawings;
FIG. 1A illustrates an existing system for cooling one or more semiconductor devices during operation;
FIG. 1B a circuit schematic for the system shown in FIG. 1A;
FIG. 2A illustrates a perspective view of a cooling system for cooling one or more semiconductor devices (e.g., power semiconductor devices) during their operation, according the current subject matter;
FIG. 2B illustrates an example of the cold plate or cooling structure (terms used interchangeably herewith) that may be disposed within the die substrate , according to the current subject matter;
FIG. 3 illustrates an example cooling system for cooling one or more semiconductor devices (e.g., power semiconductor devices) during operation, according to the current subject matter;
FIG. 4A illustrates another example cooling system for cooling semiconductor devices (e.g., power semiconductor devices) during operation, according to the current subject matter;
FIG. 4B illustrates yet another example cooling system for cooling semiconductor devices (e.g., power semiconductor devices) during operation, according to the current subject matter; and
FIG. 5 is a top view of an example of a cooling system and a corresponding circuit schematic for cooling multiple semiconductor devices during operation, according to the current subject matter.

### DETAILED DESCRIPTION

Various approaches in accordance with the present disclosure will now be described more fully hereinafter with reference to the accompanying drawings.

To address deficiencies of currently available solutions, the current subject matter relates to methods, systems, articles of manufacture, and the like that can, among other possible advantages, provide direct liquid cooling of semiconductor devices during operation of such devices.

The current subject matter relates to a cooling system for cooling one or more semiconductor devices using direct liquid cooling. The system may be used for cooling semiconductor devices, such as, for example, but not limited to, semiconductor switching devices (e.g., insulated-gate bipolar transistors (IGBTs)), diodes, and/or any other types of semiconductor devices. The system may be configured to address sudden increases (e.g., inrush) in temperatures of semiconductor device during operation, gradual temperature increases during operation, and/or maintain temperatures of the semiconductor device (and hence other circuit elements) at a predetermined temperature.

The semiconductor device(s) may be positioned on a die substrate and/or any other base plate, platform, etc. (hereinafter, referred to as "die substrate"). The die substrate may be configured to integrate, incorporate, contain and/or be a cold plate that may be configured provide cooling to the semiconductor device disposed on the die substrate. The cold plate may include one or more enclosed channels that may contain a cooling liquid. The enclosed channel(s) may be formed within the die substrate using molding, drilling, 3D printing, 3D metal printing, and/or any other desired techniques that may enable advanced internal construction of the enclosed channel as well as provide an improved thermal transfer (i.e., heat dissipation from the semiconductor device(s) positioned on the die substrate).

The cold plate may be positioned and/or disposed within the die substrate proximate to the location of the semiconductor device on the die substrate. As stated above, the cold plate may be configured to at least partially dissipate heat using the cooling liquid from the semiconductor device during operation of the semiconductor device. The cooling liquid may circulate within the enclosed channel and may enter the enclosed channel via an inlet of the enclosed channel and exit the enclosed channel via an outlet of the enclosed channel. The inlet and the outlet may be connected to a source (e.g., a container, etc.) of the cooling liquid that may be configured to keep the liquid at a predetermined temperature to allow it to cool the semiconductor device.

The cold plate may be configured to be positioned proximate to the semiconductor device. The cold plate may be positioned within and/or on the die substrate underneath and/or below and/or adjacent the semiconductor device. This way, the cooling liquid circulating within the enclosed channel of the cold plate may directly cool the semiconductor device during operation.

The semiconductor device may be coupled to another semiconductor device positioned on the same die substrate. For example, the semiconductor device may be an IGBT and the other semiconductor device may be a diode. As can be understood, the current subject matter may be used in connection with any type of semiconductor device, power semiconductor devices, thyristors, MOSFETs, etc. Coupling of the IGBT and the diode may be accomplished using at least one of the following: a bond wire, a clip, and/or any other mechanism and/or any combination thereof. The two (or more) semiconductor devices may be cooled by the same cold plate, where the cold plate may be positioned proximate to both semiconductor devices. Hence, the same cold plate may be configured to at least partially dissipate heat from one or both of the semiconductor device and the other semiconductor device during operation of one or both of them.

Alternatively, or in addition, the other semiconductor device may be cooled by its own cold plate, where such second cold plate may be disposed within the die substrate and includes its own enclosed channel containing the cooling liquid. The cooling liquid may be the same and/or different from the cooling liquid circulating in the first cold plate. The second cold plate's enclosed channel may include its own inlet and/or outlet and/or be connected to the inlet/outlet of the first cold plate's enclosed channel. In this arrangement, each cold plate can be configured to cool the semiconductor device that is positioned proximate to it (e.g., above the cold plate). The enclosed channels of both cold plates may or may not be connected to one another. If the channels are connected, then the cooling liquid from one cold plate's enclosed channel may be configured to flow to other cold plate's enclosed channel.

The cold plate containing the cooling liquid may be an electrically conductive cold plate. Alternatively, or in addition, the cold plate may be a non-conductive cold plate. As can be understood, any other type of cold plate may be used.

The current subject matter relates to a direct liquid cooling system for cooling multiple semiconductor devices. For example, the system may include a first semiconductor device (e.g., an IGBT, MOSFET, thyristor, diode, etc.) positioned on a die substrate. A first cold plate may be disposed within the die substrate proximate to and/or under the first semiconductor device. The first cold plate may include an enclosed channel that may contain a first cooling liquid. The first cold plate may be configured to at least partially dissipate heat using the first cooling liquid from the first semiconductor device during operation of the first semiconductor device. The system may also include a second semiconductor device that may be positioned on the die substrate. The first and second semiconductor devices may be positioned proximate and/or adjacent to one another and may be coupled to one another using a bond wire, a clip, etc. The second semiconductor device may be cooled by a second cold plate disposed within the die substrate and positioned adjacent and/or underneath the second semiconductor device. The second cold plate may likewise include an enclosed channel that may contain a second cooling liquid. The second cold plate may be configured to at least partially dissipate heat using the second cooling liquid from the second semiconductor device during operation of the second semiconductor device. The first and second cold plates may be galvanically isolated from the second cold plate using an isolating mechanism, where the isolating mechanism may include an isolating tube.

The cold plates may share an inlet and an outlet allowing the cooling liquid to flow in and out of both cold plates. Alternatively, or in addition, each cold plate may have its own inlet and/or outlet.

Further, the current subject matter system may be configured to perform direct liquid cooling of multiple semiconductor devices and/or multiple pairs of semiconductor devices. Each semiconductor device and/or each pair of semiconductor device and/or groups/sets of semiconductor devices may be cooled by single and/or multiple cold plate (e.g., one plate may cool one semiconductor device, one plate may cool multiple semiconductor devices, etc.). As can be understood, any way of arranging cold plates vis-a-vis semiconductor devices is possible.

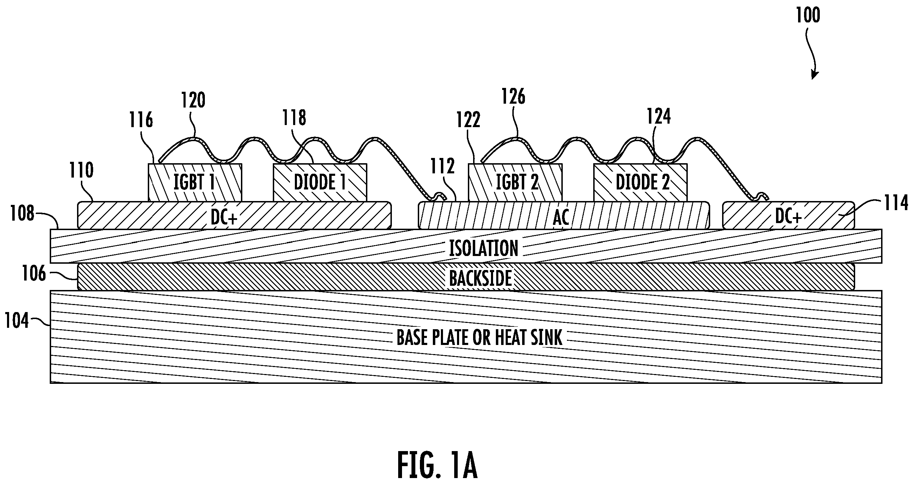

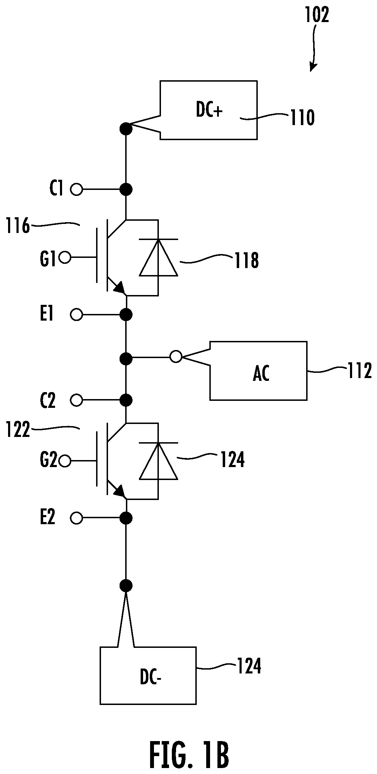

FIGS. 1A and 1B illustrate an existing system 100 and a circuit schematic 102 for cooling one or more semiconductor devices during operation. The system 100 can include a base plate layer or a heat sink 104, a backside layer 106, an isolation layer 108, and one or more terminals 110, 112, and 114 positioned on the isolation layer 108. The base plate layer 104 is coupled on top of the backside layer 106. The backside layer 106 is coupled on top of the isolation layer 108 and is formed between the isolation layer 108 and the base plate layer 104. The base plate layer 104 can include one or more heat sinks that can provide cooling to the semiconductor devices that are positioned on the isolation layer 108. The layers 104-108 can be separately formed. Alternatively, or in addition, one or more layers may be formed within another layer (e.g., through diffusion and/or any other known processes). Each of the layers 104-108 may have their own polarities that may be determined at the time of formation of the layers.

One or more semiconductor devices are positioned on the isolation layer 108 and being coupled to one or more terminals 110, 112, and/or 114. For example, semiconductor device 116 (e.g., insulated gate bipolar transistor (IGBT 1)) and semiconductor device 116 (e.g., Diode 1) can be coupled to the terminal 110 (e.g., a DC terminal). Semiconductor device 122 (e.g., IGBT 2) and semiconductor device 124 (e.g., Diode 2) can be coupled to terminal 112 (e.g., AC terminal).

An insulated gate bipolar transistor (IGBT) is a semiconductor device that is commonly used in power electronics. It combines gate-drive characteristics of metal-oxide-semiconductor field-effect transistors (MOSFETs) with the high-current and low-saturation-voltage capability of bipolar transistors. The IGBT is designed to handle large power levels and is often found in inverters, power amplifiers, and switching power supplies.

The basic structure of an IGBT includes four alternating layers of P-type and N-type semiconductor material, forming a P-N-P-N structure. This is controlled by an insulated gate similar to that of a MOSFET, which regulates the flow of current between the collector and emitter terminals. The gate terminal is insulated from the rest of the transistor by a thin layer of oxide (i.e., an "insulated gate"). The IGBT's operation is based on the gate's ability to control a larger current between the collector and emitter, making it an efficient switch for high-power applications.

A diode is a two-terminal semiconductor device that allows current to flow in one direction while blocking it in the opposite direction. A diode includes a p-n junction, which is created by doping a semiconductor material with acceptors on one side (p-type) and donors on the other (n-type). This junction forms a depletion zone that acts as a barrier to current flow when the diode is reverse-biased. When forward-biased, the external voltage reduces the width of the depletion zone, allowing current to flow. Typically, a diode is used as a rectification device for conversion of alternating current (AC) to direct current (DC).

The semiconductor devices can likewise be coupled using one or more connections 120 and/or 126. For instance, semiconductor device 116 and semiconductor device 118 can be coupled together using connection 120, which, in turn, is coupled to the terminal 112. Similarly, semiconductor device 122 and semiconductor device 124 can be coupled together using connection 126, which, in turn, is coupled to the terminal 114 (e.g., another DC terminal). As can be understood, any other semiconductor devices (e.g., MOSFETs, thyristors, etc.) and/or any combination of devices can be used. Further, semiconductor devices 116 and 118 and semiconductor devices 122 and 124 can be separated using a trench and/or any other separation techniques.

FIG. 1B illustrates the circuit schematic 102 for cooling one or more semiconductor devices of the system 100 shown in FIG. 1A. In particular, the circuit schematic 102 shows further details of various connections, including connections 120 and 126, between the semiconductor devices. As shown in FIG. 1B, the semiconductor device 116 (e.g., IGBT 1) includes a collector (C1), a gate (G1) and an emitter (E1). The semiconductor device 118 (e.g., Diode 1) is coupled between collector C1 and emitter E1 of the semiconductor device 116. The collector C1 of the semiconductor device 116 is coupled to the terminal 110 (e.g., DC terminal). The emitter E1 of the semiconductor device 116 is coupled to the terminal 112 (e.g., AC terminal).

Similarly, the semiconductor device 122 (e.g., IGBT 2) includes a collector (C2), a gate (G2) and an emitter (E2). The semiconductor device 124 (e.g., Diode 2) is coupled between collector C2 and emitter E2 of the semiconductor device 124. The collector C2 of the semiconductor device 122 is coupled to the terminal 112 (e.g., AC terminal). The emitter E2 of the semiconductor device 122 is coupled to the terminal 114 (e.g., DC terminal).

In conventional systems, the isolation layer 108 provides a required isolation between the semiconductor devices 116, 118, 122, and 124 and the base plate layer 104. Otherwise, a direct contact between the 104 and the semiconductor devices can potentially result in a short circuit between semiconductor devices 116, 118 and semiconductor devices 122, 124. However, the isolation layer 108 typically provides inadequate or insufficient thermal conductivity, thereby preventing effective cooling of the semiconductor devices positioned thereon. This leads to overheating of semiconductor devices and their breakdown, which, in turns, causes circuit failures. The current subject matter addresses these problems by directly mounting semiconductor devices to the heat sink base plate layer 104, which uses a cooling liquid to provide requisite cooling.

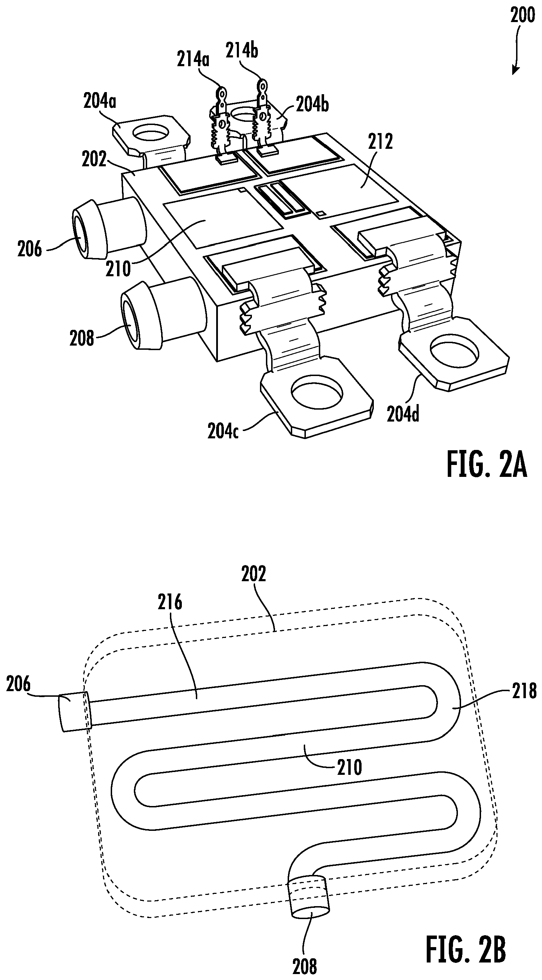

FIG. 2A illustrates a perspective view of a cooling system 200 for cooling one or more semiconductor devices (e.g., power semiconductor devices) during their operation, according to the current subject matter.

The system 200 may include a die substrate 202, one or more terminals 204 (a, b, c, d) that may be coupled to the die substrate 202, a cooling inlet 206, a cooling outlet 208, a semiconductor device 210, and a semiconductor device 212. The semiconductor devices 210 and 212 may be coupled to the die substrate 202. The semiconductor devices 210, 212 may also be coupled to one or more terminals 204. In particular, the terminals 204 may be coupled to one or more terminals of the devices 210, 212.

The terminals 204 may be coupled to the die substrate 202 using direct copper bonding (DCB) technique. DCB is a process that enhances electrical and thermal performance of power electronic devices. It involves direct attachment of copper conductors to a ceramic substrate without an intermediate layer by having a thin layer of copper oxide on the copper surface react with the ceramic to form a strong chemical bond at high temperature. DCB provides a robust and low-resistance electrical path for power devices, which is advantageous for efficient operation and heat dissipation. It allows for higher power densities and improved reliability.

The die substrate 202 may include a cooling structure 216 (as shown in FIG. 2B) that is disposed within the die substrate 202 and which the semiconductor device 210 and semiconductor device 212 may be configured to directly contact. The cooling structure 216 may be configured to contain a cooling liquid that may be supplied to the cooling structure via the cooling inlet 206 and may exit the cooling structure via the cooling outlet 208. The cooling inlet 206 and cooling outlet 208 may be formed in one or more sides of the die substrate 202, as for example, is shown in FIG. 2A. The cooling inlet 206 and cooling outlet 208 may allow coupling of one or more sources of the cooling liquid (not shown in FIG. 2A). As can be understood, the cooling inlet 206 and cooling outlet 208 may be positioned anywhere on the die substrate 202 (e.g., top, bottom, sides, etc. of the die substrate 202). Further, while FIG. 2A illustrates cooling inlet 206 and cooling outlet 208 being positioned on the same side of the die substrate 202 and adjacent one another, it may be understood, that the inlet 206 and the outlet 208 may be positioned separately from one another (as, for example is shown in FIG. 2B).

FIG. 2B illustrates an example of the cold plate or cooling structure 216 (terms used interchangeably herewith) that may be disposed within the die substrate 202, according to the current subject matter. As stated above, the cooling structure 216 may include the cooling inlet 206 and cooling outlet 208 that may be connected using a cooling channel 218. The cooling channel 218 may be configured to circulate the cooling liquid 220 between the cooling inlet 206 and the cooling outlet 208. The die substrate 202 may be configured as the cold plate 216 and/or the cold plate 216 may be disposed within the die substrate 202. The cold plate 216 may be configured as an electrically conductive liquid cold plate. As discussed herein, the cold plate may be molded into the die substrate 202 and/or formed as the die substrate. Alternatively, or in addition, various three-dimensional printing techniques may be used to form the cold plate 216, which may allow for more advanced structuring of the cold plate 216 and an improved thermal transfer.

As shown in FIG. 2B, the cooling channel 218 may have a zig-zag shape, which may allow the cooling liquid 220 to flow in different directions (e.g., side-to-side and up-and-down), thereby cooling the semiconductor devices that may be positioned on top of the die substrate 202. As can be understood, the cooling channel 218 may have any desired shape and/or form. The cooling liquid 220 may be any desired cooling liquid, such as for example, but not limited to a de-ionized water, ethylene glycol, propylene glycol, mineral oil, and/or any dielectric fluids, and/or any other liquids and/or any combinations thereof.

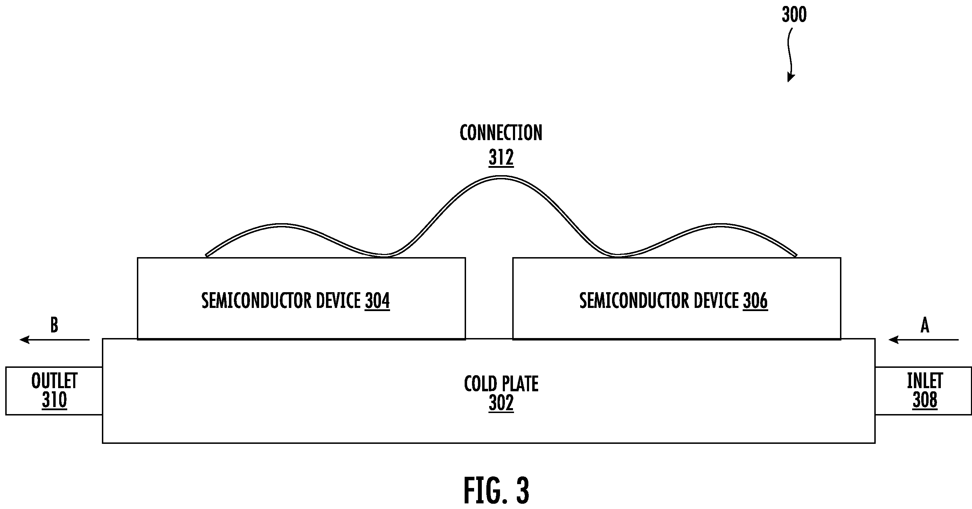

FIG. 3 illustrates an example cooling system 300 for cooling one or more semiconductor devices (e.g., power semiconductor devices) during operation, according to the current subject matter. The system 300 may be similar to the system 200 shown in FIGS. 2A-B. The system 300 may include a cold plate 302, an inlet 308, and an outlet 310. For example, the cold plate 302 may be similar to the cooling structure 216 shown in FIG. 2. The inlet 308 may be similar to cooling inlet 206, and the outlet 310 may be similar to the cooling outlet 208, as shown in FIGS. 2A-B. The system 300 may be used for cooling a single semiconductor switch and/or a pair of semiconductor devices (e.g., IGBT and a diode) during operation.

As shown in FIG. 3, a semiconductor device 304 (e.g., an IGBT) and a semiconductor device 306 (e.g., a diode) may be mounted on the cold plate 302. The semiconductor device 304 and the semiconductor device 306 may be connected using connection 312. The connection 312 may include, for example, a bond wire, a clip, and/or any other type of connection. The connection 312 may be similar to the connection 120 and/or 126 shown in FIGS. 1A-B.

The inlet 308 may be used to allow entry of cooling liquid (e.g., cooling liquid 220 as shown in FIG. 2B) in a direction A, as shown in FIG. 3, to allow it to travel through the cold plate 302's channel toward the outlet 310 and exit the outlet 310 in a direction B, as shown in FIG. 3. Traversal of the cooling liquid through the cold plate 302 between inlet 308 and outlet 310 may allow cooling of the semiconductor device 304 and semiconductor device 306. The inlet 308 and the outlet 310 may be coupled to a source of cooling liquid (not shown in FIG. 3). The source of the cooling liquid may cool liquid and resupply the cold plate 302's channel with cooled cooling liquid for further cooling and/or maintaining a desired operating temperature of the semiconductor devices 304, 306. Alternatively, or in addition, the cold plate 302 may be self-contained and not include the inlet 308 and/or outlet 310. The cooling liquid withing the cold plate 302 may be kept cold using any other desired means. As stated above, the cooling liquid may include, for example, but not limited to a de-ionized water, ethylene glycol, propylene glycol, mineral oil, and/or any dielectric fluids, and/or any other liquids and/or any combinations thereof.

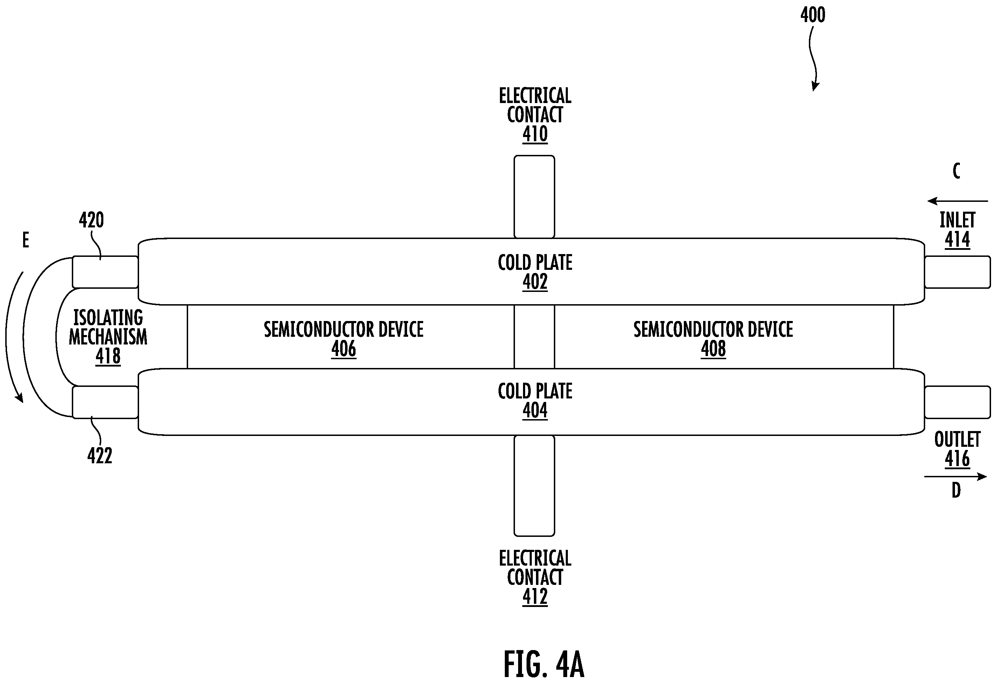

FIG. 4A illustrates another example cooling system 400 for cooling semiconductor devices (e.g., power semiconductor devices) during operation, according to the current subject matter. The system 400 may be similar to the system 300 shown in FIG. 3. The system 400 may include a cold plate 402, a cold plate 404, an inlet 414, an outlet 416, and an isolating mechanism 418 connecting the inlet channel 420 and outlet channel 422. The inlet channel 420 may extend through cold plate 402 from the inlet 414 to the isolating mechanism 418. The outlet channel 422 may extend from the isolating mechanism 418 through the cold plate 404 to the outlet 416. One or more electrical contacts 410 and 412 may be electrically coupled to the cold plates 402 and 404. For example, the electrical contact 410 may be electrically coupled the cold plate 402, and the electrical contact 412 may be electrically coupled to the cold plate 404.

The cold plates 402 and cold plate 404 may be similar to the cold plate 302 shown in FIG. 3. The inlet 414 may be similar to inlet 308, and the outlet 416 may be similar to the outlet 310, as shown in FIG. 3. As stated above, the system 400 may be used for cooling single and/or multiple semiconductor switches and/or pairs of semiconductor devices (e.g., IGBT and a diode) during operation. The system 400 may allow cooling such semiconductor switches/devices from multiple sides. As shown in FIG. 4A, the semiconductor device 406 and the semiconductor device 408 may be "sandwiched" between the cold plate 402 and the cold plate 404, thereby enhancing the cooling effect and/or achieving a desired operating temperature of the devices 406, 408. Alternatively, or in addition, the semiconductor devices 406, 408 may be positioned on top, bottom, etc. of the cold plate(s) 402 and/or 404 and/or arranged with respect to one or both of the cold plate(s) 406, 408 in any desired way.

Similar to FIG. 3, the semiconductor device 406 may be an IGBT and the semiconductor device 408 may be a diode. Both devices may be coupled to the cold plate 402 and the cold plate 404. The electrical contact 410 and/or the electrical contact 412 may be used for connection to the semiconductor device 406 and/or the semiconductor device 408.

The inlet channel 420 and the outlet channel 422 may be connected using isolating mechanism 418. The inlet channel 420, the isolating mechanism 418, and the outlet channel 422 may allow flow of cooling liquid from the inlet 414 through cold plate 402, the isolating mechanism 418, through cold plate 404, and to outlet 416. In particular, the inlet 414 may allow entry of the cooling liquid (e.g., cooling liquid 220 as shown in FIG. 2B) in a direction C to allow it to travel through the cold plate 404 toward the inlet channel 420, at which point, the cooling liquid may travel through the isolating mechanism 418 in the direction E, as shown in FIG. 4A. The cooling liquid may then continue through the outlet channel 422 toward the outlet 416 in a direction D. Traversal of the cooling liquid through the cold plates 402 and 404 between inlet 414 and outlet 416 may allow "dual" cooling of the semiconductor device 406 and semiconductor device 404. Again, the inlet 414 and the outlet 416 may be coupled to a source of cooling liquid (not shown in FIG. 4A). Alternatively, or in addition, no source of cooling liquid may be used by the system 400, where the cooling liquid may be self-contained circulating between the inlet point (e.g., as defined by inlet 414) and outlet point (e.g., as defined by outlet 416). As discussed above, the cooling liquid may include, for example, but not limited to a de-ionized water, ethylene glycol, propylene glycol, mineral oil, and/or any dielectric fluids, and/or any other liquids and/or any combinations thereof.

As can be understood, the terms "inlet" and "outlet", as used herein, as for being used for illustrative purposes only and are not intended to limit the subject matter therein. Hence, the cooling liquid may enter an outlet and exit through the inlet and vice versa, allowing circulatory flow of the liquid in any desired direction. In that regard, the directions of liquid flow as shown in the figures are provided herein for, again, illustrative purposes only and are intended to limit the current subject matter.

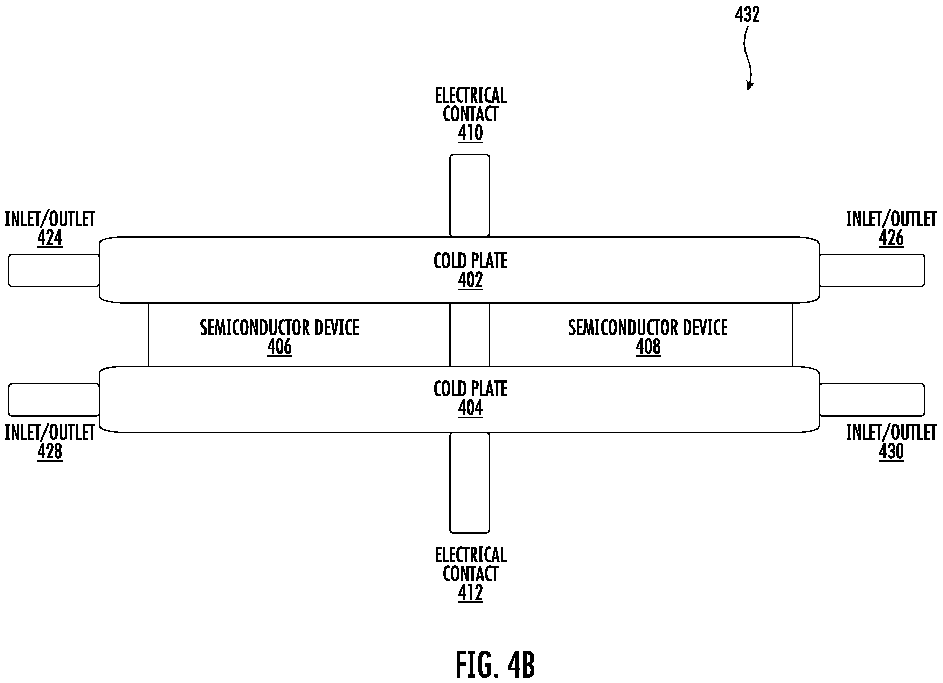

FIG. 4B illustrates another example cooling system 432 for cooling semiconductor devices (e.g., power semiconductor devices) during operation, according to the current subject matter. The system 432 may be similar to the system 300 shown in FIG. 3 as well as system 400 shown in FIG. 4A. The system 432 may similarly include the cold plates 402 and 404, each of which may be coupled to respective inlets/outlets 424, 426, 428, 430. For example, the cold plate 402 may be coupled to inlets/outlets 424 and 426, and the cold plate 404 may be coupled to inlets/outlets 428, 430. Thus, as shown in FIG. 4B, each cold plate 402, 404 may be independently coupled to one or more sources (same and/or different (not shown in FIG. 4B)) of the cooling liquid that may be supplied through one or more of its respective inlets/outlets, where the cooling liquid may exit through the other respective inlet/outlet. For example, for cold plate 402, the cooling liquid may be supplied through inlet/outlet 424, may pass through the cold plate 402 (as discussed herein), and then may exit through the inlet/outlet 426 (and vice versa). Similar arrangement may be present for cold plate 404. The cooling liquids may pass through cold plates 402, 404, as discussed herein, in the same (e.g., from inlet/outlets 424, 428 to respective inlets/outlets 426, 430) and/or opposite directions (e.g., for cold plate 402, from inlet/outlet 424 to inlet/outlet 426, and for cold plate 404, from inlet/outlet 430 to inlet/outlet 428, and/or vice versa).

Similar to the system 400 shown in FIG. 4A, one or more electrical contacts 410 and 412 may be electrically coupled to the cold plates 402 and 404. For example, the electrical contact 410 may be electrically coupled the cold plate 402, and the electrical contact 412 may be electrically coupled to the cold plate 404. The cold plates 402 and cold plate 404 may be similar to the cold plate 302 shown in FIG. 3. Moreover, the cold plate 402 and the cold plate 404 may be galvanically isolated from one another using an isolation mechanism (e.g., isolation mechanism 418 as shown in FIG. 4A). Alternatively, or in addition, no isolation mechanism is used to separate the cold plates 402, 404. The inlets/outlets 424, 426, 428, 430 may be similar to inlet 308 and/or outlet 310, as shown in FIG. 3. Similar to the system 400, the system 432 may be used to cool single and/or multiple semiconductor switches and/or pairs of semiconductor devices (e.g., IGBT and a diode) during operation. The system 432 may likewise allow cooling of such semiconductor switches/devices from multiple sides, but in the case of system 432, the cooling plates may be configured to perform cooling independently of one another. One cooling plate may serve as a fail-safe cooling device in the event the other one fails. The semiconductor devices 406, 408 may be "sandwiched" between the cold plates 402, 404 and/or positioned on and/or proximate/adjacent/etc. to one or both cold plates 402, 404 in any desired fashion. As can be understood, any number of semiconductor devices 406, 408 may be positioned on the cold plates 402, 404 and/or any number of cold plates 402, 404 (whether connected as shown in FIG. 4A, and/or independent of one another, as shown in FIG. 4B, and/or in any combination thereof) may be used. This may allow for cooling of multiple semiconductor devices and/or ensuring that such semiconductor device are operating at desired operating temperature. Moreover, the cold plates may be configured to cool only a portion of semiconductor devices (e.g., among a plurality of semiconductor devices) while other semiconductor devices are not cooled. As can be understood, any arrangement of cold plates and/or semiconductor device is possible.

Similar to FIG. 4A, the semiconductor device 406 may be an IGBT and the semiconductor device 408 may be a diode, and/or vice versa, and/or any other types of semiconductor devices. As discussed herein, the devices 406, 408 may be coupled to the cold plates 402, 404. The electrical contacts 410 and/or 412 may be used for connection to the semiconductor device(s) 406 and/or 408.

While cold plates 402, 404 may be coupled to one or more same/different sources of cooling liquid (same and/or different type of cooling liquid) using respective outlets 424, 426, 428, 430, no source(s) of cooling liquid may be used by the system 432, where the cooling liquid may be self-contained circulating between the inlet/outlet points (e.g., as defined by the inlets/outlets 424, 426 for cold plate 402, and the inlets/outlets 428, 430 for cold plate 404). As discussed herein, the cooling liquid may include, for example, but not limited to, a de-ionized water, ethylene glycol, propylene glycol, mineral oil, and/or any dielectric fluids, and/or any other liquids and/or any combinations thereof.

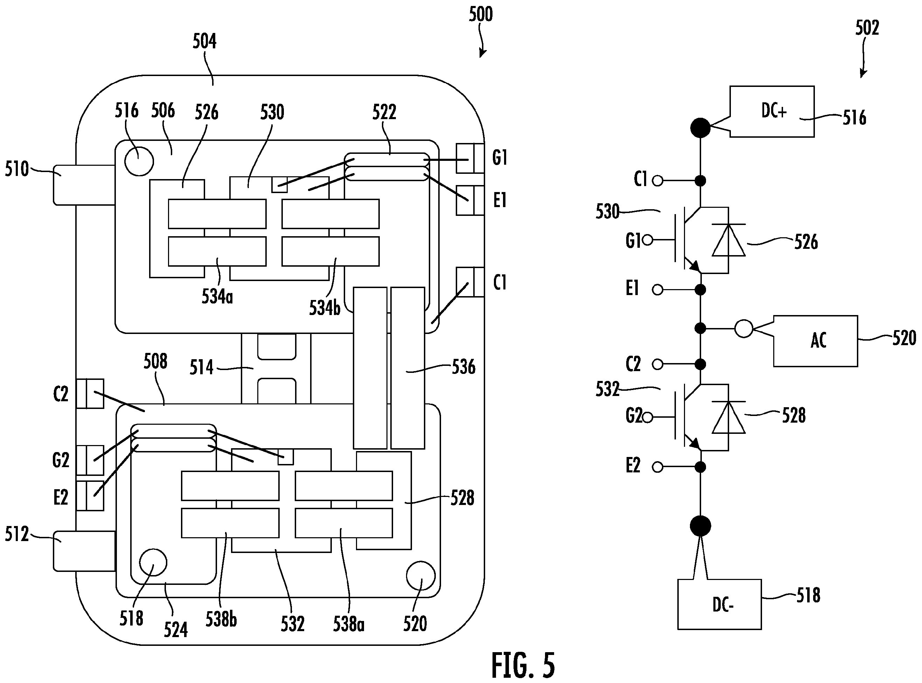

FIG. 5 is a top view of an example of a cooling system 500 and a corresponding circuit schematic 502 for cooling multiple semiconductor devices during operation, according the current subject matter. In particular, the system 500 may be configured to provide cooling and/or desired temperature maintenance for two pairs of semiconductor devices, e.g., a pair of IGBT/diode combinations.

As shown in FIG. 5, the system 500 may include a die substrate 504, a cold plate 506, a 508, an inlet 510 connected to the cold plate 506, an outlet 512 connected to the cold plate 508, an isolation mechanism 514 connected to the cold plate 506 and the cold plate 508. The cold plate 506 and the cold plate 508 may be positioned on the die substrate 504 and/or integrated, embedded, incorporated, etc. into the die substrate 504. The inlet 510 may be configured to provide an entry or a port for supply of cooling liquid to the cold plate 506. The cooling liquid may circulate through the cold plate 506 and then pass through the isolation mechanism 514 to the cold plate 508. The cooling liquid may then also circulate through the cold plate 508 and exit through the outlet 512. Both inlet 510 and outlet 512 may serve as entry and/or exit ports for the cooling liquid to reach the cold plates 506, 508. As discussed herein, the inlet 510 and/or the outlet 512 may be coupled to a source of cooling liquid that may keep the cooling liquid at a desired temperature. Alternatively, or in addition, the cold plates 506, 508 may be self-contained, whereby the cooling liquid may circulate within and/or between the cold plates 506, 508 and remain at a desired temperature to allow for direct cooling of the semiconductor devices positioned on the cold plates 506, 508.

As stated above, a pair of semiconductor devices may be positioned on each cold plate 506, 508. For example, a diode 526 and an IGBT 530 may be positioned on and/or coupled to the cold plate 506. Likewise, a diode 528 and an IGBT 532 may be positioned on and/or coupled to the cold plate 508. The diode 526 may be electrically coupled to the IGBT 530 using a connection 534a. A direct copper bonding pad 522 may also be positioned on and/or coupled to (e.g., using DCB process) the cold plate 506. The IGBT 530 may be electrically coupled to the direct copper bonding pad 522 using a connection 534b. The direct copper bonding pad 522 may allow for electrical coupling between two cold plates 506, 508 and hence, pairs of semiconductor devices disposed on the respective cold plates. In particular, the direct copper bonding pad 522 may be electrically coupled to the cold plate 508 using a connection 536.

Similar to the cold plate 506 arrangement, the diode 528 may be electrically coupled to the IGBT 532 using a connection 538a. A direct copper bonding pad 524 may also be positioned on and/or coupled to (e.g., using DCB process) the cold plate 508. The IGBT 532 may be electrically coupled to the direct copper bonding pad 524 using a connection 538b. In this case, the direct copper bonding pad 524 may include a terminal 518 (e.g., DC- terminal).

Each cold plate 506 and 508 may include electrical connection terminals to allow for electrical coupling of the semiconductor devices disposed on the cold plates to other circuit elements (not shown in FIG. 5). These terminals may be similar to terminals 204 (a, b, c, d), as shown in FIGS. 2A-B. For example, cold plate 506 may include a terminal 516 (e.g., DC+ terminal). The cold plate 508 may include the terminal 518 (e.g., DC- terminal) and a terminal 520 (e.g., AC terminal).

Further, the terminals (e.g., gate, collector, emitter) of the IGBT devices 524 and 530 may also be coupled to the respective cold plates 506, 508 and/or the direct copper bonding pads 522, 524. In particular, the collector terminal (C1) of the IGBT 530 may be electrically coupled to the cold plate 506. The gate terminal (G1) and the emitter terminal (E1) of the IGBT 530 may be electrically coupled to the direct copper bonding pad 522. Similarly, the collector terminal (C2) of the IGBT 532 may be electrically coupled to the cold plate 508. Its gate terminal (G2) and the emitter terminal (E2) may be electrically coupled to the direct copper bonding pad 524.

The circuit schematic 502 shown in FIG. 5 further illustrates various electrical connections between semiconductor devices and terminals. In particular, the diode 526 is coupled between collector C1 and emitter E1 of the IGBT 530. The collector C1 of the IGBT 530 is coupled to the terminal 516 (e.g., DC+ terminal). The emitter E1 of the IGBT 530 is coupled to the terminal 520 (e.g., AC terminal). The diode 528 is coupled between collector C2 and emitter E2 of the IGBT 532. The collector C2 of the IGBT 532 is coupled to the terminal 520 (e.g., AC terminal). The emitter E2 of the IGBT 532 is coupled to the terminal 518 (e.g., DC- terminal).

The arrangement and/or number and/or couplings of cold plates and/or semiconductor devices shown in FIGS. 3-5 are provided herein for illustrative, non-limiting purposes. As can be understood, any type of semiconductor devices may be used and/or may be cooled using the cooling structure illustrated in FIG. 3-5. Moreover, any number of cold plates and/or arrangement thereof may be used for the purposes of cooling of semiconductor devices.

It should be noted that the die substrate (e.g., die substrate 504) may integrate, incorporate, contain and/or be the cold plate and/or have portions that are cold plates (e.g., cold plates 506, 508), each of which may cool one or more semiconductor devices. The cold plate(s) may include one or more enclosed channels that may contain the cooling liquid (e.g., as shown in FIG. 2B). The enclosed channel(s) may be formed within the cold plate and/or the die substrate using molding, drilling, 3D printing, 3D metal printing, and/or any other desired techniques that may enable advanced internal construction of the enclosed channel as well as provide an improved thermal transfer (i.e., heat dissipation from the semiconductor device(s) positioned on the die substrate).

Further, as can be understood, the current subject matter may be used in connection with any type of semiconductor device, power semiconductor devices, thyristors, MOSFETs, etc. Coupling of the IGBT and the diode may be accomplished using at least one of the following: a bond wire, a clip, and/or any other mechanism and/or any combination thereof. The two (or more) semiconductor devices may be cooled by the same cold plate, where the cold plate may be positioned proximate to both semiconductor devices. Hence, the same cold plate may be configured to at least partially dissipate heat from one or both of the semiconductor device and the other semiconductor device during operation of one or both of them.

Alternatively, or in addition, the other semiconductor device may be cooled by its own cold plate (e.g., diode 526 and IGBT 530 may be cooled using cold plate 506, and diode 528 and IGBT 532 may be cooled using cold plate 508). The cooling liquid may be the same and/or different from the cooling liquid circulating in each cold plate. The cold plates may share an inlet and an outlet for the cooling liquid and/or each plate may have its own inlet and/or outlet.

The cold plate may be an electrically conductive cold plate. Alternatively, or in addition, the cold plate may be a non-conductive cold plate. As can be understood, any other type of cold plate may be used.

The current subject matter system may advantageously be configured to perform direct liquid cooling of single and/or multiple semiconductor devices and/or multiple pairs of semiconductor devices. Each semiconductor device and/or each pair of semiconductor device and/or groups/sets of semiconductor devices may be cooled by single and/or multiple cold plate (e.g., one plate may cool one semiconductor device, one plate may cool multiple semiconductor devices, etc.). As can be understood, any way of arranging cold plates vis-a-vis semiconductor devices is possible.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example. Accordingly, division, omission or inclusion of block functions depicted in the accompanying figures does not infer that the hardware components, circuits, software and/or elements for implementing these functions would necessarily be divided, omitted, or included.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

In one aspect, a system may include at least one semiconductor device positioned on a die substrate; and at least one cold plate disposed within the die substrate and containing a cooling liquid; the at least one cold plate is positioned proximate to the at least one semiconductor device and is configured to at least partially dissipate heat using the cooling liquid from the at least one semiconductor device during operation of the at least one semiconductor device.

The system may also include wherein the at least one cold plate includes an enclosed channel containing the cooling liquid.

The system may also include wherein the enclosed channel includes an inlet and an outlet, wherein the inlet is configured to allow inflow of the cooling liquid into the enclosed channel and the outlet is configured to allow outflow of the cooling liquid from the enclosed channel.

The system may also include wherein the cooling liquid is configured to circulate within the enclosed channel.

The system may also include at least another semiconductor device positioned on the die substrate, the at least another semiconductor device is coupled to the at least one semiconductor device.

The system may also include wherein the at least one semiconductor device and the at least another semiconductor device are coupled using at least one of the following: a bond wire, a clip, and any combination thereof.

The system may also include wherein the at least one cold plate is positioned proximate to the at least another semiconductor device and configured to at least partially dissipate heat from at least one of: the at least one semiconductor device and the at least another semiconductor device during operation of at least one of: the at least one semiconductor device and the at least another semiconductor device.

The system may also include at least another cold plate disposed within the die substrate, the at least another cold plate including another enclosed channel containing the cooling liquid; the at least another cold plate is positioned proximate to the at least another semiconductor device and is configured to at least partially dissipate heat using the cooling liquid from the at least another semiconductor device during operation of the at least another semiconductor device.

The system may also include wherein the another enclosed channel is not connected to the enclosed channel.

The system may also include wherein the another enclosed channel is connected to the enclosed channel, wherein the cooling liquid is configured to circulate between the enclosed channel and the another enclosed channel.

The system may also include wherein the at least one cold plate is positioned below at least one of: the at least one semiconductor device and the at least another semiconductor device.

The system may also include wherein the at least one semiconductor device includes a semiconductor switching device.

The system may also include wherein the semiconductor switching device includes an insulated-gate bipolar transistor.

The system may also include wherein at least another semiconductor device is a diode.

The system may also include wherein the cold plate is an electrically conductive cold plate.

In one aspect, a system may include a first semiconductor device positioned on a die substrate; a first cold plate disposed within the die substrate and containing a first cooling liquid, wherein the first cold plate is positioned proximate to the first semiconductor device and configured to at least partially dissipate heat using the first cooling liquid from the first semiconductor device during operation of the first semiconductor device; a second semiconductor device positioned on the die substrate; and a second cold plate disposed within the die substrate and containing a second cooling liquid, wherein the second cold plate is positioned proximate to the second semiconductor device and configured to at least partially dissipate heat using the second cooling liquid from the second semiconductor device during operation of the second semiconductor device; wherein the first cold plate is galvanically isolated from the second cold plate using an isolating mechanism.

The system may also include wherein the first cold plate includes a first enclosed channel containing the cooling liquid; the second cold plate include a second enclosed channel containing the cooling liquid; at least one of the first and second enclosed channels include an inlet and an outlet, wherein the inlet is configured to allow inflow of the cooling liquid into at least one of the first and second enclosed channels and the outlet is configured to allow outflow of the cooling liquid from at least one of the first and second enclosed channels; wherein the cooling liquid is configured to circulate within the first and second enclosed channels.

The system may also include wherein the first semiconductor device includes an insulated-gate bipolar transistor and the second semiconductor device is a diode.

The system may also include wherein the cold plate is an electrically conductive cold plate.

In one aspect, a system may include a first cold plate containing a first cooling liquid, wherein the first cold plate is positioned proximate to a first semiconductor device and configured to at least partially dissipate heat using the first cooling liquid from the first semiconductor device during operation of the first semiconductor device; and a second cold plate containing a second cooling liquid, wherein the second cold plate is positioned proximate to a second semiconductor device and configured to at least partially dissipate heat using the second cooling liquid from the second semiconductor device during operation of the second semiconductor device, wherein the second cold plate is separate from the first cold plate.

The foregoing description has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

## Claims

1. A system, comprising:
at least one semiconductor device positioned on a die substrate; and
at least one cold plate disposed within the die substrate and containing a cooling liquid;
the at least one cold plate is positioned proximate to the at least one semiconductor device and configured to at least partially dissipate heat using the cooling liquid from the at least one semiconductor device during operation of the at least one semiconductor device.

2. The system of claim 1, wherein the at least one cold plate includes an enclosed channel containing the cooling liquid, preferably wherein the enclosed channel includes an inlet and an outlet, wherein the inlet is configured to allow inflow of the cooling liquid into the enclosed channel and the outlet is configured to allow outflow of the cooling liquid from the enclosed channel.

3. The system of claim 2, wherein the cooling liquid is configured to circulate within the enclosed channel.

4. The system of any of the preceding claims, further comprising at least another semiconductor device positioned on the die substrate, the at least another semiconductor device is coupled to the at least one semiconductor device.

5. The system of claim 4, wherein the at least one semiconductor device and the at least another semiconductor device are coupled using at least one of the following: a bond wire, a clip, and any combination thereof.

6. The system of claim 4 or 5, wherein the at least one cold plate is positioned proximate to the at least another semiconductor device and configured to at least partially dissipate heat from at least one of: the at least one semiconductor device and the at least another semiconductor device during operation of at least one of: the at least one semiconductor device and the at least another semiconductor device.

7. The system of any of the claims 2-6, further comprising at least another cold plate disposed within the die substrate, the at least another cold plate including another enclosed channel containing the cooling liquid;
the at least another cold plate is positioned proximate to the at least another semiconductor device and is configured to at least partially dissipate heat using the cooling liquid from the at least another semiconductor device during operation of the at least another semiconductor device, preferably wherein the another enclosed channel is not connected to the enclosed channel.

8. The system of claim 7, wherein the another enclosed channel is connected to the enclosed channel, wherein the cooling liquid is configured to circulate between the enclosed channel and the another enclosed channel.

9. The system of any of the claims 4-8, wherein the at least one cold plate is positioned below at least one of: the at least one semiconductor device and the at least another semiconductor device.

10. The system of any of the preceding claims, wherein the at least one semiconductor device includes a semiconductor switching device, preferably wherein the semiconductor switching device includes an insulated-gate bipolar transistor.

11. The system of any of the preceding claims 4-10, wherein at least another semiconductor device is a diode.

12. The system of any of the preceding claims, wherein the cold plate is an electrically conductive cold plate.

13. Use of the system according to any of the preceding claims, in cooling the semiconductor device.

14. A system, comprising:
a die substrate for positioning a semiconductor device; and
a cold plate disposed within the die substrate and containing a cooling liquid;
the cold plate positionable proximate to the semiconductor device, the cold plate configured to at least partially dissipate heat, using the cooling liquid, from the semiconductor device during operation of the semiconductor device.

15. Use of the system according claim 14 for cooling a semiconductor device.
